# EUROPEAN PATENT SPECIFICATION

(11) **EP 2 284 871 B1**
(45) Date of publication and mention of the grant of the patent: **10.10.2012**
(21) Application number: 09754566.9
(22) Date of filing: 13.05.2009
(51) Int. Cl.: H01L 31/18, H01L 27/142, B28D 1/22, B28D 5/00, C03B 33/07, C03B 33/10, C03C 17/36, H01L 21/67

(54) **SCRIBE APPARATUS FOR THIN FILM SOLAR CELL**
ANREISSVORRICHTUNG FÜR EINE DÜNNFILM-SOLARZELLE
APPAREIL DE DÉCOUPE POUR PILE SOLAIRE À COUCHES MINCES

(30) Priority: 26.05.2008 JP 2008136865
(43) Date of publication of application: 16.02.2011
(73) Proprietor: Mitsuboshi Diamond Industrial Co., Ltd., Suita-city, Osaka 564-0044 (JP)
(72) Inventor: SOYAMA, Masanobu, Suita-city Osaka 564-0044 (JP)
(74) Representative: TBK
(86) International application number: PCT/JP2009/058931
(87) International publication number: WO 2009/145058

(56) References cited:
- WO-A1-03/040049
- JP-A- 2000 315 809
- JP-A- 2004 115 356
- JP-A- 2004 115 356
- JP-A- 2007 145 681
- JP-A- 2007 145 681
- JP-A- 2008 116 969
- JP-U- 63 016 439
- US-A- 4 057 184

## Description

### Technical Field

The present invention relates to a scribing apparatus for a thin film solar cell with which the thin film on the surface of a thin film solar cell can be scribed with high precision.

### Background Art

These days many countries are facing important issues relating to energy and CO₂ emissions, and the development of solar batteries, which are an energy source with no CO₂ emissions, has been progressing rapidly. In particular, many solar batteries using a CIGS (Cu(InGn)Se₂) based chalcopyrite compound for the light absorbing layer have been developed, because the efficiency of photoelectric conversion is high and the structure allows for stable output properties.

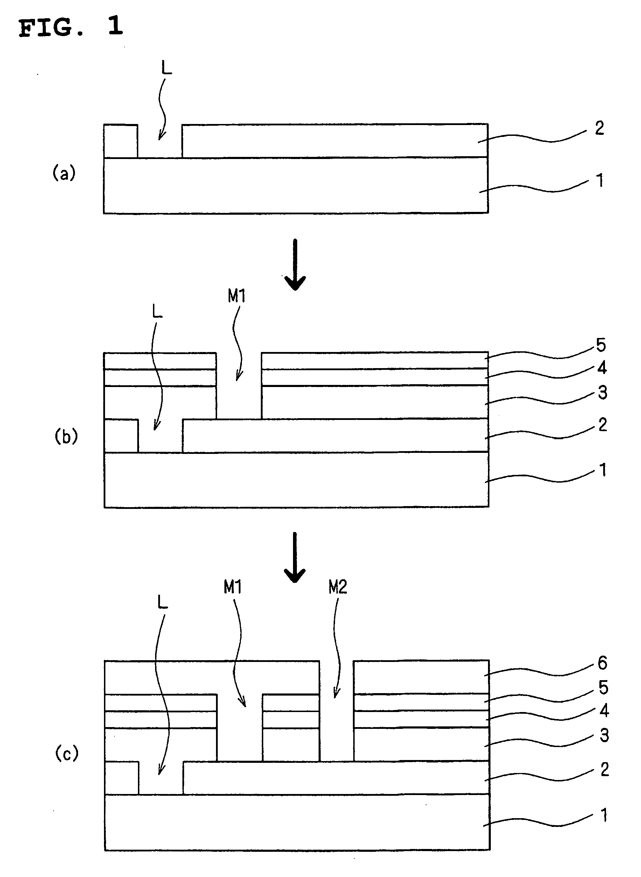

Figs 1(a) to 1(c) are schematic diagrams showing the steps in the manufacture of a CIGS based thin film solar cell. In Fig 1(a) an Mo electrode layer 2 that serves as a positive lower electrode is formed on an SLG (soda lime glass) substrate 1 through sputtering, and a trench L for separating the lower electrode is created through scribing.

Next, in Fig 1(b), a light absorbing layer 3 made of a compound semiconductor (CIGS) thin film is formed on the Mo electrode layer 2, and a buffer layer 4 made of a ZnS thin film for a hetero junction is formed on top in accordance with CBD (chemical bus deposition), an insulating layer 5 made of a ZnO thin film is formed on top of this through sputtering, and a trench M1 for the contact between electrodes is created through scribing at a distance from the side of the trench L for separating the lower electrode by a predetermined distance so as to extend to the Mo electrode layer 2.

In addition, in Fig 1(c) a transparent electrode layer 6 that serves as an upper electrode is formed of a ZnO : A1 thin film on top of the insulating layer 5, and a trench M2 for separating the electrode is created through scribing so as to extend to the lower Mo electrode layer 2.

In the case where laser scribing is used to create the trenches M1 and M2 in the process for manufacturing a CIGS based thin film solar cell, there is a risk that the efficiency of photoelectric conversion in the light absorbing layer 3 may lower due to the heat from the laser beam. Therefore, in Patent Documents 1 and 2, for example, a blade of which the cylindrical end portion is tapered is pressed against the surface, so that the scribing process is carried out mechanically, without using a laser bream.
In Patent Document 3, a mechanical scribing process is described, wherein a cylindrical scribing head is pressed against the surface of the thin film solar cell. The direction in which the scribe head moves, i.e the scribing direction, is perpendicular to the center line of the cylinder.
Patent Document 1: Japanese Unexamined Patent Publication 2002-94089
Patent Document 2: Japanese Unexamined Patent Publication 2004-115356
Patent Document 3 Japanese Utility Model JP63016439U

### Disclosure of the Invention

### Problem to Be Solved by the Invention

In the scribing apparatuses disclosed in Patent Documents 1 and 2, however, the blade is a conical needle with a predetermined taper, and the end portion is cut so that the surface that is pressed against the substrate is flat and the contact area is large. Accordingly, the thin film peels relatively easily albeit irregularly, and thus a problem arises, such that it is difficult to carry out the scribing process with high precision.

In particular, it is necessary for the depth of peeling of the thin film to be constant in order to keep the width of the scribe line constant. Though the load with which the blade is pressed against the substrate can be adjusted in accordance with the properties of the substrate, the pressure on the surface of the substrate increases and decreases uniformly, and therefore it is difficult to minutely adjust the pressure.

The present invention is provided in view of the above described problems, and an object of the invention is to provide a scribing apparatus for a thin film solar cell with which the width of a scribe line to be created is easy to adjust.

### Means for Solving Problem

In order to achieve the above described object, the scribing apparatus for a thin film solar cell according to the invention is provided with: a support means for supporting a substrate of a thin film solar cell; a scribe head for pressing the blade installed at an end against a line to be scribed on one surface of the above described substrate; and a moving means for moving said scribe head over the above described substrate, wherein a scribe line is created on one surface of the above described substrate when the above 2 described scribe head moves over the above described substrate, characterized in that in the above described scribe head the end of the above described blade is in cylindrical form and the above described blade is positioned so that the direction in which the scribe head moves is approximately the same as the direction of the center line of the cylinder.

According to the invention, the scribe head is moved over the substrate so that the blade is pressed against one surface of the substrate of a thin film solar cell along the line to be scribed. That is to say, the substrate may be moved and the scribe head fixed, the scribe head may be moved with the substrate fixed, or the two may both be moved. The end of the blade of the scribe head is in cylindrical form, and the blade is positioned so that the direction of movement is approximately the same as the direction of the center line of the cylinder. Since the end of the blade of the scribe head is in cylindrical form, when the blade is pressed against the surface of the substrate and moved over the substrate, the pressure applied to the thin film on the surface gradually becomes smaller in a direction approximately perpendicular to the direction in which the blade is moving from the center portion, in which the blade makes initial contact with the substrate, and thus the pressure changes smoothly along the border along which the thin film peels, and there are no abrupt changes. Accordingly, the probability of the thin film accidentally peeling along the border portion is low, and the thin film can be peeled along a desired scribe line. In addition, it is possible to easily adjust the width of the line to be scribed by increasing and reducing the radius of the blade in cylindrical form and the pressure.

In addition, the scribing apparatus for a thin film solar cell according to the invention is the scribing apparatus for a thin film solar cell according to the first invention, characterized in that at least the blade of the above described scribe head is made of a hard metal.

According to the invention, the blade of the scribe head is made of a hard metal, and therefore the life of the blade is long and the blade barely deforms, and thus it is possible to carry out a scribing process with high precision for a long of time.

### Effects of the Invention

In the above described structure, the end of the blade of the scribe head is in cylindrical form, and therefore when the blade is pressed against the surface of the substrate and moved over the substrate, the pressure applied to the thin film on the surface gradually becomes smaller in a direction approximately perpendicular to the direction in which the blade is moving from the center portion, in which the blade makes initial contact with the substrate, and thus the pressure changes smoothly along the border along which the thin film peels, and there are no abrupt changes. Accordingly, the probability of the thin film accidentally peeling along the border portion is low, and the thin film can be peeled along a desired scribe line. In addition, it is possible to easily adjust the width of the line to be scribed by increasing and reducing the radius of the blade in cylindrical form and the pressure.

### Brief Description of the Drawings

Figs 1(a) to 1(c) are schematic diagrams showing the steps for manufacturing a CIGS based thin film solar cell;
Fig 2 is a schematic diagram showing the structure of a scribing apparatus for a thin film solar cell according to one embodiment of the present invention;
Fig 3 is a perspective diagram showing the structure of the blade of a conventional scribing apparatus for a thin film solar cell;
Fig 4 is a schematic diagram showing how a scribe line is created in the case where a conventional blade is used;
Fig 5 is a perspective diagram showing the structure of the blade of the scribing apparatus for a thin film solar cell according to the present invention; and
Fig 6 is a schematic diagram showing how a scribe line is created in the case where the blade according to the present invention is used. Explanation of Symbols

- 18: table
- 19: bridge
- 20: support pillar
- 21: guide bar
- 22: guide
- 23: holder support
- 9: holder
- W: substrate for solar cell
- 7: scribe head
- 8: blade

### Best Mode for Carrying Out the Invention

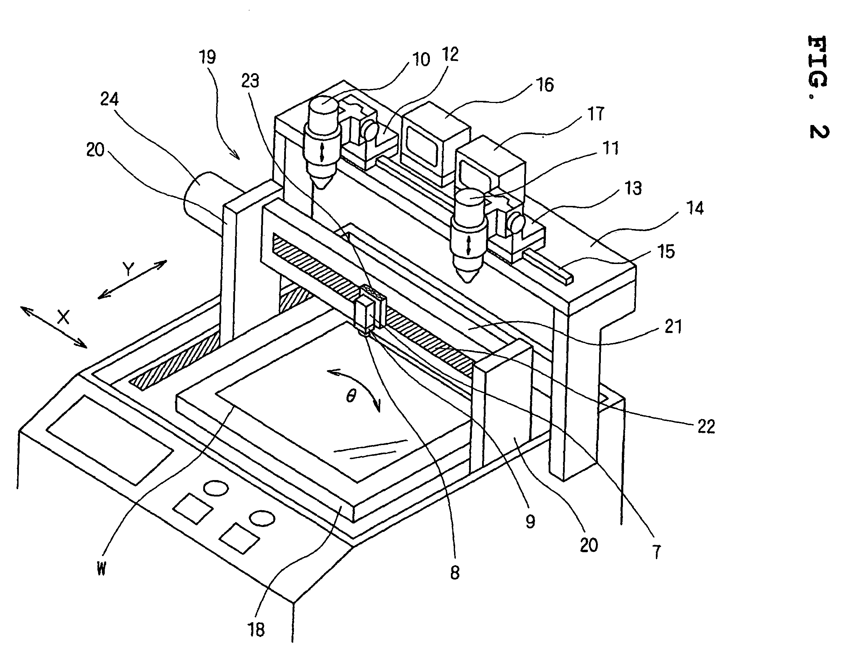

In the following, an embodiment of the present invention is described in detail in reference to the drawings. Fig 2 is a schematic diagram showing the structure of the scribing apparatus for a thin film solar cell according to one embodiment of the present invention. As shown in Fig 2, the scribing apparatus for a thin film solar cell according to this embodiment can be moved in an approximately horizontal direction (direction Y), and is equipped with a table 18 that is rotatable 90 degrees by an angle θ.

A bridge 19 formed of support pillars 20, 20 and a guide bar 21 that runs in the direction X is provided over the table 18 with the support pillars on either side thereof. A holder support 23 can move in the direction X along the guide 22 formed on the guide bar 21 as the motor 24 rotates.

A holder support 23 is provided with a scribe head 7, and a holder 9 for holding the blade 8 with which a scribing process is carried out on the surface of the thin film of the substrate W for a solar cell mounted on the table 18 is provided beneath the scribe head 7.

In addition, cameras 10 and 11 are mounted on bases 12 and 13 that can move in the direction X and the direction Y The bases 12 and 13 move along the guide 15 provided on the support 14, which extends in the direction X. The cameras 10 and 11 can be moved up and down through manual operation, so that the focal point is adjustable. Images taken by the cameras 10 and 11 are displayed on monitors 16 and 17.

There is an alignment mark for determining the position of the surface of the substrate W for a solar cell mounted on the table 18, and the position of the substrate W for a solar cell can be adjusted on the basis of the images of the alignment mark as taken by the cameras 10 and 11. In other words, the location of the substrate W for a solar cell that is mounted on the table 18 can be determined from the images of the alignment mark as taken by the cameras 10 and 11. Any shift of the substrate W for a solar cell can be detected when it is positioned, and the location can be corrected by rotating the table 18 by the necessary angle θ on the basis of the alignment mark.

In addition, whenever the table 18 is moved with a predetermined pitch in the direction Y, the scribe head 7 is lowered so that the blade 8 presses against the surface W for a solar cell, and in this state the scribe head 7 is moved in the direction X, so that a scribing process is carried out on the surface of the substrate W for a solar cell in the direction X. In the case where a scribing process is carried out on the surface of the substrate W for a solar cell in the direction Y, the same operation is carried out after the table 18 is rotated by 90 degrees.

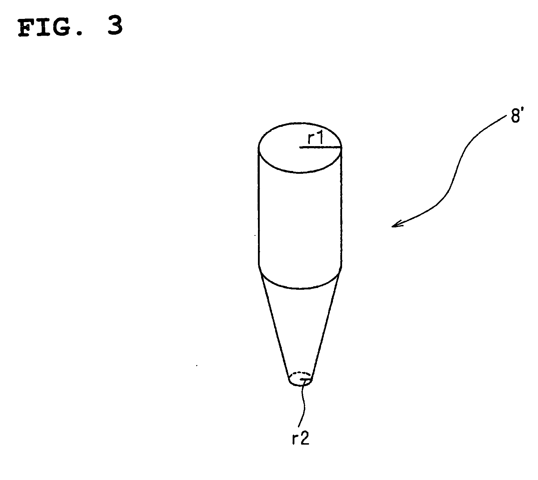

The end portion of the scribe head 7 is provided with the blade 8 for peeling the thin film from the surface of the substrate W for a solar cell. Fig 3 is a perspective diagram showing the structure of the blade of a conventional scribing apparatus for a thin film solar cell.

As shown in Fig 3, the blade 8' is in cylindrical form with the end portion tapered. In addition, the end portion is cut off in a direction approximately perpendicular to the center line of the cylinder in order to secure a certain area on the surface for peeling the thin film of the substrate W for a solar cell, so that the end portion is a truncated cone. Thus, the cross section of the cylindrical portion is a circle with a radius r1, and the end of the truncated cone is a circle with a smaller radius r2. This blade 8' is pressed against the thin film on the surface of the substrate W for a solar cell while the scribe head 7 moves over the substrate in the direction Y along the line to be scribed, so that a scribing process is carried out.

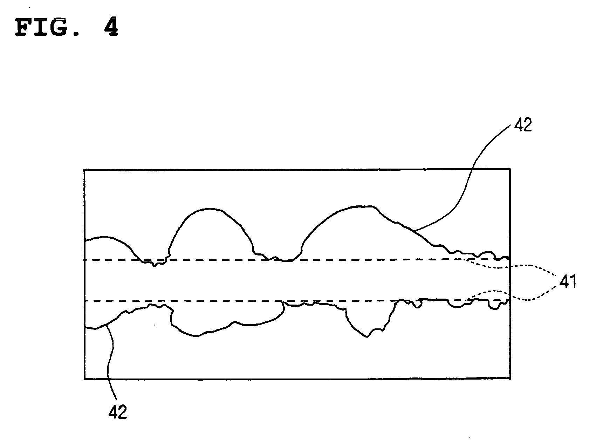

Fig 4 is a schematic diagram showing how a scribe line is created in the case where a conventional blade 8' is used. In the case where a conventional blade 8' is used, as in Fig 4, the line 41 can be scribed as planned (broken line), but there are a number of points where the thin film excessively peels.

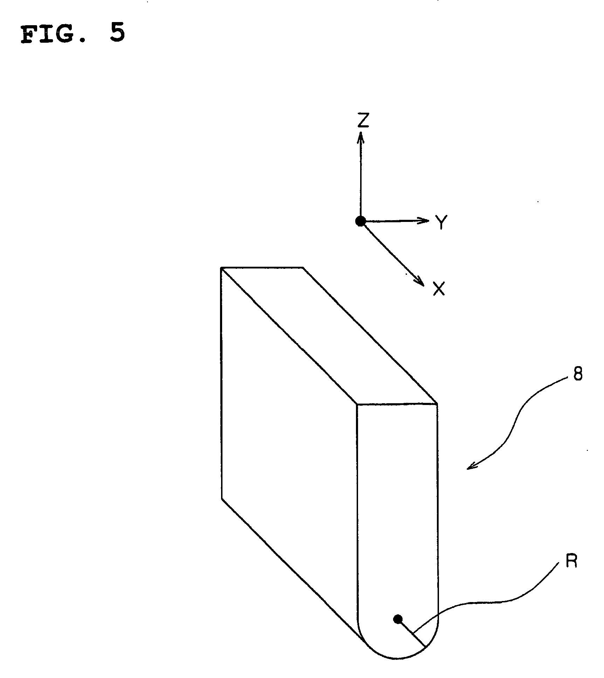

For this reason, in the present embodiment the form of the blade 8 is cylindrical. Fig 5 is a perspective diagram showing the structure of the blade 8 in the scribing apparatus for a thin film solar cell according to the present embodiment.

As shown in Fig 5, the blade of the scribing apparatus according to the present embodiment has an end portion in cylindrical form. That is to say, the cross section of the blade 8 in a plane perpendicular to the direction X is a half circle with a radius R in the end portion, and this blade 8 is pressed against the thin film on the surface of the substrate W for a solar cell while the scribe head 7 is moved over the substrate in the direction X, so that a scribing process is carried out.

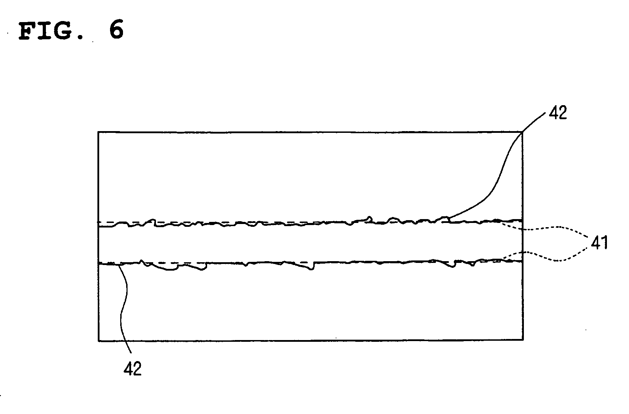

Fig 6 is a schematic diagram showing how a scribe line is created in the case where the blade 8 according to the present embodiment is used. As shown in Fig 6, the line 41 can be traced with higher precision than in the case where the conventional blade 8' is used (broken line), and there are much less points where the film peels excessively. This is because the blade 8 is in cylindrical form and the pressure on the thin film on the surface becomes gradually smaller toward the outside of the blade from the center when the blade 8 moves over the substrate while pressing against the surface W for a solar cell, so that the pressure changes smoothly across the border along which the thin film peels. Accordingly, the thin film does not accidentally peel along the border portion, and the thin film can be peeled along a desired scribe line.

In addition, the width of the line to be scribed is easy to adjust. That is to say, since the blade 8 is in cylindrical form, the radius R of the half circle in a cross section of the blade 8 in a plane perpendicular to the direction X can be made larger or smaller and the pressure of the blade 8 can be increased or decreased, so that a scribe line with a desired width can be created.

The material for the blade 8 of the scribe head 7 may be diamond (single crystal, sintered (PCD) or the like) or a hard metal. In the case where the blade 8 is formed of a hard metal, the thin film can be peeled to the same degree with lower pressure than in the case of diamond, and thus it is possible to adjust the width of the line to be scribed within a wider range.

Though in the above described embodiment a scribing process is carried out by moving the scribe head 7 in the direction X with the substrate W for a solar cell fixed, the scribe head 7 may move in the direction Y, the scribe head 7 may be fixed with only the substrate W for a solar cell moving in the direction X or the direction Y, or both the scribe head 7 and the substrate W for a solar cell may be moved. In any case, the orientation of the blade 8 can be adjusted so that the blade 8 moves in the direction of the line along which the end portion of the blade 8 in cylindrical form makes contact with the substrate W for a solar cell.

## Claims

1. A scribing apparatus for a thin film solar cell, comprising:
a support means (18) for supporting a substrate (W) of a thin film solar cell;
a scribe head (7) for pressing the blade (8) installed at an end against a line to be scribed on one surface of said substrate (W); and
a moving means (23) for moving said scribe head (7) over said substrate (W),
the scribe head (7) is moved over the substrate (W) so that the blade (8) is pressed against one surface of the substrate (W) of a thin film solar cell along the line to be scribed,
**characterized in that**
in said scribe head (7) the end of said blade (8) is in cylindrical form and said blade (8) is positioned so that the direction in which the scribe head (7) moves is approximately the same as the direction of the center line of the cylinder.

2. The scribing apparatus for a thin film solar cell according to Claim 1, **characterized in that** at least the blade (8) of said scribe head (7) is made of a hard metal.

## Patentansprüche

1. Anreißvorrichtung für eine Dünnschichtsolarzelle, mit:
einem Stützmittel (18) zum Stützen eines Substrats (W) einer Dünnschichtsolarzelle;
einem Anreißkopf (7) zum Drücken der an einem Ende installierten Klinge (8) gegen eine auf einer Oberfläche des Substrats (W) anzureißende Linie; und
einem Bewegungsmittel (23) zum Bewegen des Anreißkopfs (7) über das Substrat (W),
wobei der Anreißkopf (7) so über das Substrat (W) bewegt ist, dass die Klinge (8) entlang der anzureißenden Linie gegen eine Oberfläche des Substrats (W) einer Dünnschichtsolarzelle gedrückt ist,
**dadurch gekennzeichnet, dass**
in dem Anreißkopf (7) das Ende der Klinge (8) in zylindrischer Form vorliegt und die Klinge (8) so positioniert ist, dass die Richtung, in der sich der Anreißkopf (7) bewegt, annähernd die Gleiche wie die Richtung der Mittellinie des Zylinders ist.

2. Anreißvorrichtung für eine Dünnschichtsolarzelle nach Anspruch 1,
**dadurch gekennzeichnet, dass**
zumindest die Klinge (8) des Anreißkopfs (7) aus einem Hartmetall hergestellt ist.

## Revendications

1. Appareil de traçage pour une cellule solaire en couches minces, comprenant :
un moyen de support (18) permettant de maintenir un substrat (W) d'une cellule solaire en couches minces ;
une tête de traçage (7) permettant de presser la lame (8) installée à une extrémité contre une ligne à tracer sur une surface dudit substrat (W) ; et
un moyen de déplacement (23) permettant de déplacer ladite tête de traçage (7) sur ledit substrat (W),
la tête de traçage (7) est déplacée sur le substrat (W) de sorte que la lame (8) soit pressée contre une surface du substrat (W) d'une cellule solaire en couches minces le long de la ligne à tracer,
**caractérisé en ce que**
dans ladite tête de traçage (7) l'extrémité de ladite lame (8) présente une forme cylindrique et ladite lame (8) est placée de sorte que la direction dans laquelle la tête de traçage (7) se déplace soit à peu près la même que la direction de la ligne centrale du cylindre.

2. Appareil de traçage pour une cellule solaire en couches minces selon la revendication 1, **caractérisé en ce qu'**au moins la lame (8) de ladite tête de traçage (7) est réalisée en un métal dur.
